# FASCICULE DE BREVET EUROPEEN

(11) **EP 0 610 130 B1**
(45) Date de publication et mention de la délivrance du brevet: **24.06.1998**
(21) Numéro de dépôt: 94400210.4
(22) Date de dépôt: 01.02.1994
(51) Int. Cl.: H01L 33/00, H01L 21/20, H01S 3/19

(54) **Procédé de fabrication d'un composant semiconducteur notamment d'un laser à arête enterrée**
Verfahren zur Herstellung eines Halbleiterbauteils, insbesondere eines Lasers mit vergrabener Streifenwellenleiterstruktur
Method of manufacturing à semiconductor component, in particular a buried ridge laser

(30) Priorité: 04.02.1993 FR 9301212
(43) Date de publication de la demande: 10.08.1994
(73) Titulaire: ALCATEL ALSTHOM COMPAGNIE GENERALE D'ELECTRICITE, 75008 Paris (FR)
(72) Inventeur: Goldstein, Léon, F-92370 Chaville (FR); Bonnevie, Dominique, F-91310 Leuville sur Orge (FR)
(74) Mandataire: Bourely, Paul

(56) Documents cités:
- APPLIED PHYSICS LETTERS. vol. 54, no. 22 , 29 Mai 1989 , NEW YORK US pages 2171 - 2173 H. JUNG AND E. SCHLOSSER 'InP/InGaAsP buried mesa ridge laser: A new ridge laser with reduced leakage currents'
- PATENT ABSTRACTS OF JAPAN vol. 11, no. 212 (E-522)9 Juillet 1987 & JP-A-62 032 679 (NEC CORP) 12 Février 1987
- PATENT ABSTRACTS OF JAPAN vol. 13, no. 307 (E-787)13 Juillet 1989 & JP-A-01 082 585 (TOSHIBA CORP) 28 Mars 1989

## Description

La présente invention concerne la fabrication de certains composants semi-conducteurs. Ces composant sont ceux dont la fabrication comporte le dépôt d'un revêtement dopé sur une surface perturbée d'une base dopée par un dopant de même type de conductivité que ce revêtement. Cette base et ce revêtement sont typiquement constitués d'un même matériau semi-conducteur et doivent en tous cas présenter une continuité cristalline.

La surface mentionnée ci-dessus a typiquement été perturbée par un traitement agressif, tel qu'une photolithogravure, nécessaire pour la réalisation d'une structure de ce composant, et le dépôt du revêtement sur cette surface est typiquement réalisé par un procédé connu de dépôt épitaxial, tel que l'épitaxie par jets moléculaires. Cette surface constitue donc une surface de reprise de dépôt épitaxial. Elle sera appelée ci-après plus brièvement "surface de reprise".

Il est apparu que les composants ainsi fabriqués présentaient parfois des défauts de fonctionnement.

La présente invention a pour but d'éviter d'une manière simple de tels défauts.

Selon cette invention, telle que décrite dans la revendication 1, les opérations de dépôt du revêtement comportent le dépôt, au voisinage de ladite surface perturbée, d'une couche surdopée du même type de conductivité présentant une concentration en dopant supérieure au double de la concentration moyenne de ce revêtement.

Dans le cadre de cette invention il a en effet été trouvé que certains des défauts de fonctionnement précédemment constatés provenaient du fait que des défauts de structure ou de composition présentés par la surface de reprise modifiaient localement la population des porteurs de charges électriques dans le composant fabriqué. Plus précisément ils provoquent parfois, au voisinage de cette surface, des effets nuisibles tels qu'une déplétion de porteurs ou une inversion du type de conductivité.

La présente invention permet d'éviter ces effets nuisibles.

A l'aide des figures schématiques ci-jointes, on va décrire plus particulièrement ci-après, à titre d'exemple non limitatif, comment la présente invention peut être mise en oeuvre. Lorsqu'un même élément est représenté sur plusieurs figures il y est désigné par un même signe de référence. Il doit être compris que les éléments mentionnés peuvent être remplacés par d'autres éléments assurant les mêmes fonctions techniques.

Les figures 1 à 3 représentent des vues en coupe d'un laser semi-conducteur à arête enterrée à des étapes successives de sa fabrication.

La figure 4 représente une vue à échelle agrandie d'un détail IV de la figure 3.

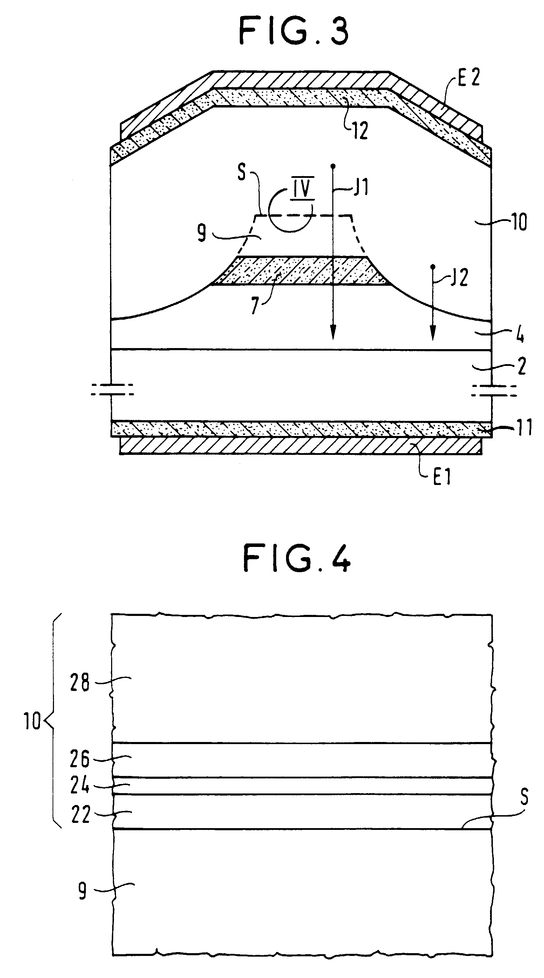

En se référant aux figures 3 et 4 on va tout d'abord décrire de manière générale un procédé mettant la présente invention en oeuvre pour le dépôt d'un revêtement dopé 10 sur une surface perturbée S d'une base 9 dopée par un dopant de même type de conductivité que ce revêtement.

Pour la fabrication d'un composant semi-conducteur à base de phosphure d'indium, ce procédé comporte les étapes suivantes qui sont connues en elles mêmes:
- Formation d'une base. Cette base est constituée de phosphure d'indium monocristallin. Elle comporte des couches 2, 4, 6 et une couche supérieure 8 munie d'un dopant de type p à une concentration dite ci-après "de base".qui est comprise entre 10¹⁷ cm⁻³ et 5.10¹⁸ cm⁻³.
- Application d'un traitement agressif tel qu'une gravure à cette base pour former une structure dudit composant. A la suite de ce traitement au moins une zone subsistante 9 de la couche supérieure 8 de la base présente une surface dite ci-après "de reprise" S dont la structure cristalline et éventuellement la composition chimique sont perturbées.
- Enfin, sur cette surface de reprise, dépôt d'un revêtement 10. Ce revêtement est constitué de phosphure d'indium. Il comporte un dopant de type p constitué de beryllium. Une concentration moyenne de ce dopant dans ce revêtement sera appelée ci-après "concentration de revêtement moyenne". Elle est comprise entre 10¹⁷ cm⁻³ et 5.10¹⁸ cm⁻³. Ce dépôt est réalisé par épitaxie par jets moléculaires pour que cette couche de revêtement soit en continuité cristalline avec la couche de base.

Selon la présente invention cette étape de dépôt d'un revêtement 10 comporte elle même une étape de dépôt d'une couche surdopée 24 présentant en beryllium une concentration dite "de correction" supérieure à 6.10¹⁸ cm⁻³ et au double de ladite concentration de revêtement moyenne. Cette couche surdopée est déposée à une distance de la surface de reprise S inférieure à 20nm. De préférence son épaisseur est comprise entre 5 et 20nm et la concentration de correction est comprise entre 10¹⁹ cm⁻³ et 6.10¹⁹ cm⁻³.

De préférence, avant le dépôt de la couche surdopée 24, on dépose une couche initiale de reprise 22 présentant une concentration sensiblement nulle en dopant et une épaisseur comprise entre 5 et 20nm.

De préférence encore, après le dépôt de la couche surdopée 24, on dépose une couche finale de reprise 26 présentant une concentration en dopant inférieure à la concentration de revêtement moyenne et une épaisseur supérieure à celle de l'ensemble des deux couches initiale de reprise 22 et surdopée 24. C'est après le dépôt de cette couche finale de reprise que l'on dépose une couche principale de revêtement 28 présentant une concentration en beryllium sensiblement égale à la concentration de revêtement moyenne qu'il convient d'obtenir. L'épaisseur de cette couche principale est supérieure à celle de l'ensemble des trois couches initiale de reprise 22, surdopée 24, et finale de reprise 26.

On va maintenant décrire des problèmes posés par la fabrication d'un laser à arête enterrée et un procédé de fabrication d'un tel laser mettant en oeuvre la présente invention.

Les documents JP-A-62 032 679 et JP-A-1 082 585 décrivent des procédés de fabrication d'un tel laser utilisant des couches fortement dopées avant la formation de l'arête.

Un tel laser est représenté à la figure 3. Sa structure est connue internationalement sous la dénomination anglaise "Buried Ridge Structure" (BRS).

Elle est notamment décrite dans les documents de brevets EP-A-45 678 (CNET) et US-A-4 441 187. Elle pourra aussi être comprise à l'aide de la description ci-après de sa fabrication.

Elle incorpore deux diodes connectées en parallèle. L'une de ces diodes est constituée par une hétérojonction utile comportant un ruban de confinement supérieur 9 de type p, un ruban laser 7 et une couche de confinement inférieure 4 de type n. L'autre diode est constituée par une homojonction latérale parasite comportant un revêtement 10 de type p et la même couche de confinement inférieure 4.

La diode constituée par l'hétérojonction est passante sous une tension d'alimentation U comprise entre 0,6 et 0,9V typiquement. Celle constituée par l'homojonction latérale est passante sous une tension plus élevée. Pour des tensions intermédiaires le courant passe principalement en J1 par l'hétérojonction donc à travers le ruban laser 7 avec génération de photons par effet laser. Mais une composante de courant parasite J2 passe alors aussi par l'homojonction. Cette composante est faible dans la mesure où les couches 4 et 10 sont fortement dopées. Typiquement les dopages sont de l'ordre de: n = 1.10¹⁸ cm⁻³ dans la couche 4 et p = 2.10¹⁸ cm⁻³ dans la couche 10.

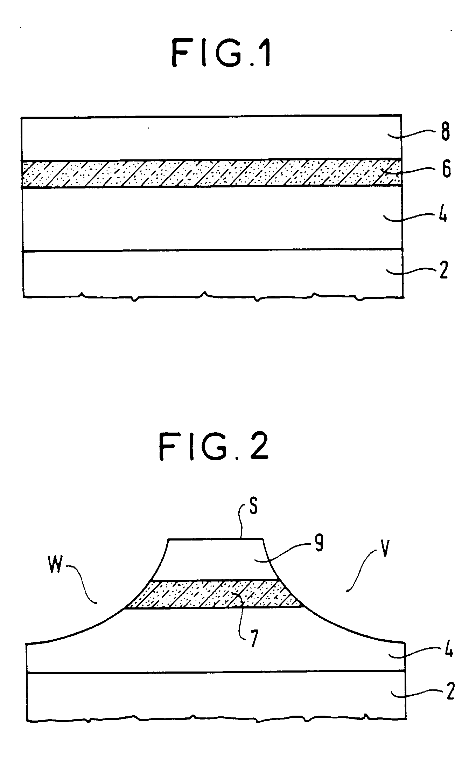

Un procédé de fabrication d'un tel laser selon la présente invention comporte les étapes connues suivantes réalisées en continuité cristalline sur un substrat 2 de phosphure d'indium (voir figure 1):
- Formation d'une couche de confinement inférieure 4 de phosphure d'indium de type n.
- Dépôt d'une couche active 6 de composition au moins ternaire sur cette couche de confinement inférieure.
- Dépôt d'une couche de confinement supérieure 8 de phosphure d'indium de type p sur cette couche active. Cette couche de confinement supérieure constitue la couche supérieure de la base précédemment mentionnée.
- Gravure pour éliminer les couches de confinement supérieure et active dans deux vallées V, W en laissant subsister entre ces deux vallées un plateau 7, 9 allongé selon une direction longitudinale (voir figure 2). Cette gravure est une photolithogravure de type classique. Des parties des couches active et de confinement supérieure subsistant dans ce plateau constituent respectivement un ruban laser 7 et un ruban de confinement supérieur 9. Cette gravure constitue le traitement agressif précédemment mentionné. Elle est réalisée de manière classique et fait apparaître une surface de reprise S constituée par la surface exposée du ruban de confinement supérieur. Cette surface présente des défauts liés aux impuretés résiduelles (oxygène, carbone, silicium,...) ou aux écarts à la stoechiométrie (lacunes de phosphore, états d'interfaces...) qui n'ont pas pu être totalement éliminés par les techniques de nettoyage chimique (hors réacteur de croissance), ou de nettoyage in situ (dans un réacteur, avant reprise du dépôt épitaxial).
- Enfin dépôt du revêtement 10 de phosphure d'indium précédemment mentionné. Ce dépôt est réalisé par épitaxie par jets moléculaires. Il constitue la reprise de dépôt précédemment mentionnée. Ce revêtement inclue un dopant de type p constitué de beryllium et il comporte les couches suivantes:
- Couche initiale de reprise 22 : InP non dopé épaisseur : 10nm.
- Couche surdopée 24: InP concentration en Be=3.10¹⁹ cm⁻³, épaisseur : 10nm.
- Couche finale de reprise 26: InP non dopé, épaisseur 35nm.
- InP dopé Be à la concentration moyenne de revêtement (typiquement 7.10¹⁷ cm⁻³ à 10¹⁸ cm⁻³, épaisseur typiquement comprise entre 1,5 µm et 3,5 µm.

On forme en outre des couches de contact 11 et 12 et des électrodes E1, E2 sous ledit substrat 2 et sur ledit revêtement. Ces électrodes permettent d'appliquer la tension d'alimentation U entraînant le passage d'un courant d'alimentation entre elles. Comme précédemment expliqué, la composante utile J1 de ce courant passe à travers l'hétérojonction comportant le ruban laser 7. Les porteurs de charge injectés par cette composante permettent à ce ruban laser d'amplifier une lumière guidée par ce ruban selon ladite direction longitudinale. De manière générale les concentrations de dopage des couches de confinement supérieure 9 et inférieure 4 et du revêtement sont choisies pour qu'il existe une gamme de valeurs de la tension d'alimentation U telles que la composante parasite du courant d'alimentation J2 soit faible devant sa composante utile J1.
Le composant semi-conducteur fabriqué selon cette invention présente une bonne qualité de l'homojonction InP (n/p) à l'interface des couches 4 et 10 et une continuité électrique InP (p/p) à l'interface des couches 9 et 10 nettement meilleure que les composants analogues fabriqués par les procédés connus. Cette amélioration semble être liée aux faits suivants:

Les défauts présents à la surface de reprise S et précédemment mentionnés sont électriquement actifs et constituent des donneurs de type n. Après le dépôt du revêtement d'InP de type p sur la base d'InP de type p, la présence de centres donneurs n à l'interface constituée par la surface S peut créer localement une déplétion de porteurs, c'est-à-dire une zone de type p qui est peu dopée en raison d'une compensation par les centres donneurs n et qui est donc trop résistive. Il peut même apparaître une inversion du type de conductivité au passage de l'interface. Ces phénomènes de déplétion ou d'inversion empêchent un fonctionnement normal du composant.

Dans le cas où on utilise des techniques de dépôt telles que l'épitaxie en phase liquide (EPL), l'épitaxie en phase vapeur (EPV) ou encore l'épitaxie en phase vapeur des organo-métalliques (EPVOM), ces phénomènes ne sont pas trop gênants dans la mesure où le zinc utilisé alors comme dopant p de l'InP à tendance à diffuser à travers la surface de reprise et donc à corriger ces phénomènes. Par contre, lorsque la technique de dépôt utilisée est l'épitaxie par jets moléculaires et où le beryllium est utilisé comme dopant, le fait que ce corps a un relativement faible coefficient de diffusion entraîne que les phénomènes de déplétion ou d'inversion peuvent se manifester de manière importante.

De manière un peu plus générale les avantages de la présente invention apparaîssent surtout dans les cas où le dopant utilisé a un coefficient de diffusion relativement faible.

Dans le cas du dopant beryllium, ce dopant tend à diffuser, et donc à corriger un phénomène de déplétion de porteurs p apparaissant à son voisinage, lorsque sa concentration dans la couche surdopée est supérieure à 6.10¹⁸ cm⁻³.

Dans le cadre de la fabrication du laser à arête enterrée précédemment décrit la température de diffusion est typiquement voisine de 500°C et le temps de diffusion voisin de 30 minutes.

## Revendications

1. Procédé de fabrication d'un composant semi-conducteur, ce procédé comportant les étapes de :
- formation d'une plaquette semi-conductrice (2,4,6,8) présentant une face supérieure initiale,
- attaque de ladite face supérieure initiale pour remplacer cette face supérieure initiale par une surface de reprise (W,S,V), seule une zone limitée (S) de cette surface de reprise étant dopée par un dopant d'un premier type de conductivité (p), une structure cristalline de cette surface de reprise étant perturbée, et
- dépôt d'un revêtement semi-conducteur dopé par un dopant du dit premier type de conductivité (10) sur l'ensemble de ladite surface de reprise,
ce procédé étant caractérisé par le fait que le dépôt dudit revêtement (10) comporte le dépôt, au voisinage de ladite zone limitée (S), d'une couche surdopée (24) dopée par un dopant dudit premier type de conductivité et présentant une concentration de dopage supérieure au double de la concentration de dopage moyenne dudit revêtement.

2. Procédé selon la revendication 1, ce procédé comportant les étapes suivantes:
- formation d'une base (2, 4, 6, 8) monocristalline comportant une couche supérieure (8) constituée de phosphure d'indium et munie d'un dopant de type p à une concentration "de base" comprise entre 10¹⁷ cm⁻³ et 5.10¹⁸ cm⁻³,
- application d'un traitement agressif à cette base pour former une structure dudit composant de sorte qu'au moins une zone subsistante (9) de ladite couche supérieure (8) de la base présente une surface "de reprise" (S) dont la structure cristalline est perturbée,
- et, sur cette surface de reprise, dépôt d'un revêtement (10) constitué de phosphure d'indium et comportant un dopant de type p constitué de beryllium, une concentration moyenne de ce dopant dans ce revêtement constituant une concentration de revêtement moyenne et étant comprise entre 10¹⁷ cm⁻³ et 5.10¹⁸ cm⁻³, ce dépôt étant réalisé par épitaxie par jets moléculaires pour que cette couche de revêtement soit en continuité cristalline avec cette couche de base,
ce procédé étant caractérisé par le fait que ladite étape de dépôt d'un revêtement (10) comporte une étape de dépôt d'une couche surdopée (24) présentant en beryllium une concentration de correction supérieure à 6.10¹⁸ cm⁻³ et au double de ladite concentration de revêtement moyenne, cette couche surdopée étant déposée à une distance de ladite surface de reprise (S) inférieure à 20nm.

3. Procédé selon la revendication 2, caractérisé par le fait que ladite étape de dépôt d'un revêtement (10) comporte, avant ledit dépôt d'une couche surdopée (24), une étape de dépôt d'une couche initiale de reprise (22) présentant une concentration sensiblement nulle en dopant et une épaisseur comprise entre 5 et 20nm.

4. Procédé selon la revendication 3, caractérisé par le fait que ladite étape de dépôt d'un revêtement (10) comporte encore, après le dépôt de ladite couche surdopée (24), une étape de dépôt d'une couche finale de reprise (26) présentant une concentration en dopant inférieure à ladite concentration de revêtement moyenne, ladite étape de dépôt d'un revêtement comportant encore, après le dépôt de cette couche finale de reprise, une étape de dépôt d'une couche principale de revêtement (28) présentant une concentration en beryllium sensiblement égale à ladite concentration de revêtement moyenne, et une épaisseur supérieure à celle de l'ensemble des trois dites couches initiale de reprise (22), surdopée (24), et finale de reprise (26).

5. Procédé selon la revendication 4, caractérisé par le fait que ladite couche finale de reprise (26) présente une épaisseur supérieure à celle de l'ensemble des deux dites couches initiale de reprise (22) et surdopée (24).

6. Procédé selon la revendication 2, caractérisé par le fait que ladite concentration de correction est comprise entre 10¹⁹ cm⁻³ et 6.10¹⁹ cm-3, ladite couche surdopée (24) présentant une épaisseur comprise entre 5 et 20nm.

7. Procédé de fabrication d'un laser du type à arête enterrée BRS, ce procédé faisant application du procédé de l'une quelconque des revendications 2 à 6 et comportant les étapes suivantes réalisées en continuité cristalline sur un substrat (2) de phosphure d'indium,
- formation d'une couche de confinement inférieure (4) de phosphure d'indium de type n,
- dépôt d'une couche active (6) de composition au moins ternaire sur cette couche de confinement inférieure,
- dépôt d'une couche de confinement supérieure (8) de phosphure d'indium de type p sur cette couche active, cette couche de confinement supérieure constituant ladite couche supérieure de la base,
- gravure pour éliminer lesdites couches de confinement supérieure et active dans deux vallées (V, W) en laissant subsister entre ces deux vallées un plateau (7, 9) allongé selon une direction longitudinale, des parties desdites couches active et de confinement supérieure subsistant dans ce plateau constituant respectivement un ruban laser (7) et un ruban de confinement supérieur (9), cette gravure constituant ledit traitement agressif et faisant apparaître une dite surface de reprise (S) constituée par la surface exposée dudit ruban de confinement supérieur,
- et dépôt par épitaxie par jets moléculaires dudit revêtement (10) de phosphure d'indium comportant un dopant de type p constitué de beryllium,
- ce procédé comportant encore des étapes de formation d'électrodes (E1, E2) sous ledit substrat (2) et sur ledit revêtement pour permettre d'appliquer une tension d'alimentation (U) entraînant un courant d'alimentation (J1, J2) entre ces électrodes, ce courant comportant une composante utile (J1) passant à travers une hétérojonction formée par ledit ruban de confinement supérieur (9), ledit ruban laser (7) et ladite couche de confinement inférieure (4), de manière à permettre à ce ruban laser d'amplifier une lumière guidée par ce ruban selon ladite direction longitudinale, ce courant comportant aussi une composante parasite (J2) passant à travers une homojonction formée entre ledit revêtement et ladite couche de confinement inférieure, les concentrations de dopage desdites couches de confinement supérieure (9) et inférieure (4) et dudit revêtement (R) étant choisies pour qu'il existe une valeur de ladite tension d'alimentation (U) rendant ladite composante parasite (J2) faible devant ladite composante utile (J1) du courant d'alimentation.

## Patentansprüche

1. Verfahren zum Herstellen eines Halbleiterbauteiles, welches folgende Schritte umfaßt:
- Bilden einer Halbleiterplatte (2, 4, 6, 8), die eine anfängliche obere Seite aufweist,
- Angreifen der anfänglichen oberen Seite, um diese anfängliche obere Seite durch eine Fortsetzungsoberfläche (W, S, V) zu ersetzen, wobei nur eine begrenzte Zone (S) dieser Fortsetzungsoberfläche mit einem Dotiermittel eines ersten Leitfähigkeitstyps (p) dotiert ist und eine Kristallstruktur dieser Fortsetzungsoberfläche gestört ist, und
- Abscheiden einer mit einem Dotiermittel vom besagten ersten Leitfähigkeitstyp dotierten halbleitenden Beschichtung (10) auf der gesamten Fortsetzungsoberfläche,
wobei das Verfahren dadurch gekennzeichnet ist, daß das Abscheiden der Beschichtung (10) das Abscheiden, in der Nähe der begrenzten Zone (S), einer überdotierten Schicht (24) umfaßt, die mit einem Dotiermittel vom ersten Leitfähigkeitstyp dotiert ist und eine Dotierungskonzentration aufweist, die größer als das Doppelte der mittleren Dotierungskonzentration der Beschichtung ist.

2. Verfahren nach Anspruch 1, mit folgenden Schritten:
- Bilden einer einkristallinen Basis (2, 4, 6, 8), die eine obere Schicht (8) umfaßt, die aus Indiumphosphid gebildet ist und mit einem Dotiermittel vom p-Typ bei einer "Basis"-Konzentration zwischen 10¹⁷cm⁻³ und 5x10¹⁸cm⁻³ versehen ist,
- Anwenden einer aggressiven Behandlung auf diese Basis, um eine Struktur des Bauteiles derart zu bilden, daß wenigstens eine übrigbleibende Zone (9) der oberen Schicht (8) der Basis eine "Fortsetzungs"-Oberfläche (S) aufweist, deren Kristallstruktur gestört ist,
- und, auf dieser Fortsetzungsoberfläche, Abscheiden einer Beschichtung (10), die aus Indiumphosphid gebildet ist und ein Dotiermittel vom p-Typ, gebildet aus Beryllium, umfaßt, wobei eine mittlere Konzentration dieses Dotiermittels in dieser Beschichtung eine mittlere Beschichtungskonzentration bildet und zwischen 10¹⁷cm⁻³ und 5x10¹⁸cm⁻³ liegt, wobei die Abscheidung durch Molekularstrahlepitaxie durchgeführt ist, so daß diese Beschichtungsschicht in kristalliner Kontinuität mit dieser Basisschicht ist,
dadurch gekennzeichnet, daß der Schritt des Abscheidens einer Beschichtung (10) einen Schritt des Abscheidens einer überdotierten Schicht (24) umfaßt, die an Beryllium eine Korrekturkonzentration aufweist, die größer als 6x10¹⁸cm⁻³ und als das Doppelte der mittleren Beschichtungskonzentration ist, wobei diese überdotierte Schicht in einem Abstand von weniger als 20 nm von der Fortsetzungsschicht (S) abgeschieden ist.

3. Verfahren nach Anspruch 2, dadurch gekennzeichnet, daß der Schritt des Abscheidens einer Beschichtung (10) vor besagtem Abscheiden einer überdotierten Schicht (24) einen Schritt des Abscheidens einer Anfangs-Fortsetzungsschicht (22) umfaßt, die eine im wesentlichen verschwindende Konzentration an Dotiermittel und eine zwischen 5 und 20 nm liegende Dicke aufweist.

4. Verfahren nach Anspruch 3, dadurch gekennzeichnet, daß der Schritt des Abscheidens einer Beschichtung (10) ferner nach dem Abscheiden der überdotierten Schicht (24) einen Schritt des Abscheidens einer End-Fortsetzungsschicht (26) umfaßt, die eine Konzentration an Dotiermittel aufweist, die kleiner als besagte mittlere Beschichtungskonzentration ist, wobei der Schritt des Abscheidens einer Beschichtung ferner nach dem Abscheiden dieser End-Fortsetzungsschicht einen Schritt des Abscheidens einer Haupt-Beschichtungsschicht (28) umfaßt, die eine Konzentration an Beryllium im wesentlichen gleich der mittleren Beschichtungskonzentration und eine größere Dicke als die der Anordnung der drei Schichten Anfangs-Fortsetzungsschicht (22), überdotierte Schicht (24) und End-Fortsetzungsschicht (26) aufweist.

5. Verfahren nach Anspruch 4, dadurch gekennzeichnet, daß die End-Fortsetzungsschicht (26) eine größere Dicke als die der Anordnung der zwei Schichten Anfangs-Fortsetzungsschicht (22) und überdotierte Schicht (24) aufweist.

6. Verfahren nach Anspruch 2, dadurch gekennzeichnet, daß die Korrekturkonzentration zwischen 10¹⁹cm⁻³ und 6x10¹⁹cm⁻³ liegt, wobei die überdotierte Schicht (24) eine Dicke zwischen 5 und 20 nm aufweist.

7. Verfahren zum Herstellen eines Lasers vom Typ mit vergrabener Kante (BRS), wobei das Verfahren vom Verfahren nach einem der Ansprüche 2 bis 6 Gebrauch macht und folgende, in kristalliner Kontinuität auf einem Substrat (2) aus Indiumphosphid realisierte Schritte umfaßt:
- Bilden einer unteren Einschließungsschicht (4) aus Indiumphosphid vom n-Typ,
- Abscheiden einer aktiven Schicht (6) mit wenigstens ternärer Zusammensetzung auf dieser unteren Einschließungsschicht,
- Abscheiden einer oberen Einschließungsschicht (8) aus Indiumphosphid vom p-Typ auf dieser aktiven Schicht, wobei diese obere Einschließungsschicht die obere Schicht der Basis bildet,
- Ätzen, um die obere Einschließungsschicht und die aktive Schicht in zwei Tälern (V, W) zu entfernen unter Bestehenlassen eines in einer Längsrichtung langgestreckten Plateaus (7, 9) zwischen diesen zwei Tälern, wobei in diesem Plateau bestehenbleibende Teile der aktiven Schicht und der oberen Einschließungsschicht einen Laserstreifen (7) bzw. einen oberen Einschließungsstreifen (9) bilden, wobei das Ätzen die aggressive Behandlung bildet und eine sogenannte Fortsetzungsoberfläche (S) zum Erscheinen bringt, die durch die freiliegende Oberfläche des oberen Einschließungsstreifens gebildet ist,
- und Abscheiden der Beschichtung (10) aus Indiumphosphid mit einem Dotiermittel vom p-Typ, gebildet durch Beryllium, durch Molekularstrahlepitaxie,
- wobei das Verfahren ferner die Schritte des Bildens von Elektroden (E1, E2) unter dem Substrat (2) und auf der Beschichtung umfaßt, um das Anlegen einer Versorgungsspannung (U) zu ermöglichen, die einen Versorgungsstrom (J1, J2) zwischen diesen Elektroden antreibt, wobei dieser Strom eine Nutzkomponente (J1) umfaßt, der durch einen durch den oberen Einschließungsstreifen (9), den Laserstreifen (7) und den unteren Einschließungsstreifen (4) gebildeten Heteroübergang fließt, um es dem Laserstreifen zu ermöglichen, ein durch diesen Streifen in der Längsrichtung geführtes Licht zu verstärken, wobei dieser Strom ferner auch eine parasitäre Komponente (J2) umfaßt, die durch einen zwischen der Beschichtung und der unteren Einschließungsschicht gebildeten Homoübergang fließt, wobei die Dotierungskonzentrationen der oberen (9) und unteren (4) Einschließungsschicht und der Beschichtung (R) so gewählt sind, daß ein Wert der Versorgungsspannung (U) existiert, der die parasitäre Komponente (J2) klein im Vergleich zur Nutzkomponente (J1) des Versorgungsstromes macht.

## Claims

1. A method of manufacturing a semiconductor component, the method involving the following steps:
forming a semiconductor plate (2, 4, 6, 8) having an initial top face;
etching said initial top face in order to replace said initial top face with a restart surface (W, S, V), only a limited region (S) of said restart surface being doped with a dopant of a first conductivity type (p), a crystalline structure of said restart surface being disturbed; and
depositing a doped semiconductor coating (10) on the whole of said restart surface (S), which coating is doped with a dopant of said first conductivity type;
said method being characterized by the fact that depositing said coating (10) involves depositing a superdoped layer (24) in the vicinity of said limited region, which superdoped layer is doped with a dopant of said first conductivity type and at a dopant concentration that is greater than twice the mean dopant concentration of the coating.

2. A method according to claim 1, the method including the following steps:
forming a monocrystalline base (2, 4, 6, 8) including a top layer (8) made of indium phosphide and doped with a p-type dopant at a "base" concentration lying in the range 10¹⁷ cm⁻³ to 5.10¹⁸ cm⁻³;
applying aggressive treatment to the base to form a structure of said component such that at least a remaining region (9) of said top layer (8) of the base has a "restart" surface (S) whose crystalline structure is disturbed; and
depositing a coating (10) on the restart surface, which coating is made of indium phosphide and includes a p-type dopant constituted by beryllium, the mean concentration of the dopant in the coating constituting the mean coating concentration, and lying in the range 10¹⁷ cm⁻³ to 5.10¹⁸ cm⁻³, the deposition being performed by molecular beam epitaxy so that the coating layer is in crystalline continuity with the base layer;
said method being characterized by the fact that said step of depositing a coating (10) includes a step of depositing a superdoped layer (24) having a correction concentration of beryllium that is greater than 6.10¹⁸ cm⁻³, and that is greater than twice said mean coating concentration, the superdoped layer being deposited at a distance of less than 20 nm from said restart surface (S).

3. A method according to claim 2, characterized by the fact that, prior to said deposition of a superdoped layer (24), said step of depositing a coating (10) includes a step of depositing an initial restart layer (22) having a dopant concentration that is substantially zero and a thickness lying in the range 5 nm to 20 nm.

4. A method according to claim 3, characterized by the fact that, after deposition of said superdoped layer (24), said step of depositing a coating (10) further includes a step of depositing a final restart layer (26) having a dopant concentration that is less than said mean coating concentration, and, after deposition of the final restart layer, said step of depositing a coating further includes a step of depositing a main coating layer (28) having a beryllium concentration that is substantially equal to said mean coating concentration, and thickness that is greater than the combined thickness of said initial restart layer (22), of said superdoped layer (24), and of said final restart layer (26).

5. A method according to claim 4, characterized by the fact that said final restart layer (26) has thickness that is greater than the combined thickness of said initial restart layer (22) and of said superdoped layer (24).

6. A method according to claim 2, characterized by the fact that said correction concentration lies in the range 10¹⁹ cm⁻³ to 6.10¹⁹ cm⁻³, said superdoped layer (24) having a thickness lying in the range 5 nm and 20 nm.

7. A method of manufacturing a laser of the buried ridge structure (BRS) type, the method making use of the method of any one of claims 2 to 6, and including the following steps performed in crystalline continuity on an indium phosphide substrate (2):
forming a bottom confinement layer (4) of n-type indium phosphide;
depositing an active layer (6) of at least ternary composition on the bottom confinement layer;
depositing a top confinement layer (8) of p-type indium phosphide on the active layer, the top confinement layer constituting said top layer of the base;
etching to remove said top confinement layer and said active layer along two valleys (V, W) while leaving a plateau (7, 9) that is elongate in a longitudinal direction, a portion of said active layer and a portion of said top confinement layer remaining in the plateau to constitute a laser strip (7) and a top confinement strip (9) respectively, said etching constituting said aggressive treatment, and uncovering one of said restart surfaces (S) constituted by the exposed surface of said top confinement layer; and
depositing said indium phosphide coating (10) by means of molecular beam epitaxy, which coating includes a dopant of the p-type constituted by beryllium;
said method further including steps of forming electrodes (El, E2) beneath said substrate (2) and above said coating to enable a powering voltage (U) to be applied, thereby causing a powering current (J1, J2) to flow between the electrodes, the current including a useful component (J1) passing through a heterojunction formed by said top confinement strip (9), by said laser strip (7), and by said bottom confinement layer (4), so as to enable the laser strip to amplify light guided by the strip in said longitudinal direction, the current also including a parasitic component (J2) passing through a homojunction formed between said coating and said bottom confinement layer, the doping concentrations of said top confinement layer (9), of said bottom confinement layer (4), and of said coating (R) being chosen so that one value of said powering voltage (U) makes said parasitic component (J2) small compared with said useful component (J1) of the powering current.
